# EUROPEAN PATENT APPLICATION

(11) **EP 2 296 183 A2**
(43) Date of publication of application: **16.03.2011**
(21) Application number: 10168531.1
(22) Date of filing: 06.07.2010
(51) Int. Cl.: H01L 31/0224, H01L 31/0368, H01L 31/0376

(54) **Thin film solar cell and method of manufacturing the same**

(30) Priority: 09.09.2009 KR 20090084899
(71) Applicant: LG Display Co., Ltd., Seoul 150-721 (KR)
(72) Inventor: Park, Wonseo, 411-371, Goyang-si (KR); Lee, Jeongwoo, 413-773, Paju-si (KR); Park, Seongkee, 411-310, Goyang-si (KR); Yu, YiYin, 413-779, Paju-si (KR)
(74) Representative: Viering, Jentschura & Partner

(57) **Abstract**

A thin film solar cell including a first substrate, a first electrode on the first substrate, an upper surface of the first electrode having a plurality of irregularities, an absorption layer on the first electrode, the absorption layer including amorphous silicon layers and microcrystal silicon layers contacting the first electrode at an angle relative to the first substrate, a second electrode on the absorption layer, and a second substrate on the second electrode.

## Description

This application claims the benefit of Korean Patent Application No. 10-2009-0084899 filed on September 9, which is hereby incorporated by reference.

### BACKGROUND OF THE INVENTION

### FIELD OF THE INVENTION

This document relates to a thin film solar cell and a method of manufacturing the same, and more particularly to a thin film solar cell equipped with an absorption layer that includes amorphous silicon and polysilicon and a method of manufacturing the same.

### DISCUSSION OF THE RELATED ART

In recent years, a variety of research for replacing the existing fossil fuel has been done to solve the critical energy problem. In particular, as petroleum resources will be diminished in several decades, various studies have been done on the use of natural energy, such as wind power, atomic energy, and solar energy. Among these alternatives, a solar cell using relatively infinite and environmentally friendly solar energy has been considered. Research has been done on the solar cell since the development of a Se solar cell in 1983. Current solar cells using single crystalline bulk silicon are not widely used because of their high manufacturing cost and installation costs.

In an effort to reduce costs, active research is being done on thin film solar cells. In particular, research is occurring related to manufacturing a large-area solar cell at low cost with a thin film solar cell using amorphous silicon (a-Si:H). In general, a thin film solar cell may have a structure in which a first electrode, an absorption layer, and a second electrode are stacked over a substrate. Efforts are being made to improve efficiency, such as a texturing process for forming great irregularities on a surface of the first electrode or the crystallization of amorphous silicon forming the absorption layer.

### SUMMARY OF THE INVENTION

Accordingly, the present invention is directed to a thin film solar cell and method of manufacturing the same that substantially obviates one or more problems due to limitations and disadvantages of the related art.

An object of the present invention is to provide an improved solar cell and method of manufacturing the same.

Another object of the present invention is to provide an improved solar cell capable of improving efficiency by absorbing a wide wavelength range of a visible ray, and a method of manufacturing the same.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

To achieve these and other advantages and in accordance with the purpose of the present invention, as embodied and broadly described, the thin film solar cell and method of manufacturing the same includes a thin film solar cell, including a first substrate, a first electrode on the first substrate, an upper surface of the first electrode having a plurality of irregularities, an absorption layer on the first electrode, the absorption layer including amorphous silicon layers and microcrystal silicon layers contacting the first electrode at an angle relative to the first substrate, a second electrode on the absorption layer, and a second substrate on the second electrode.

In another aspect, the thin film solar cell and method of manufacturing the same includes a thin film solar cell, including a first substrate, a first electrode on the first substrate, an upper surface of the first electrode having a plurality of irregularities, an absorption layer disposed on the first electrode, the absorption layer including an amorphous silicon layer and a microcrystal silicon layer formed parallel to the first and second electrodes, a second electrode disposed on the absorption layer, and a second substrate on the second electrode.

In another aspect, the thin film solar cell and method of manufacturing the same includes a method for fabricating a thin film solar cell, including the steps of preparing a first substrate, forming a first electrode on the first substrate, an upper surface of the first electrode having a plurality of irregularities, depositing a plurality of metal seeds on the first electrode, forming an absorption layer on the first electrode, the absorption layer including amorphous silicon layers and microcrystal silicon layers, the microcrystal layers being formed of the plurality of metal seeds, forming a second electrode on the absorption layer; and forming a second substrate on the second electrode.

In another aspect, the thin film solar cell and method of manufacturing the same includes a method for fabricating a thin film solar cell, including the steps of preparing a first substrate, forming a first electrode on the first substrate, an upper surface of the first electrode having a plurality of irregularities, forming an absorption layer on the first electrode, the absorption layer including an amorphous silicon layer and a microcrystal silicon layer, the microcrystal layer being formed by irradiating an upper surface of the amorphous silicon layer, forming a second electrode on the absorption layer, and forming a second substrate on the second electrode.

In another aspect, the thin film solar cell and method of manufacturing the same includes a method of manufacturing a thin film solar cell including the steps of forming a first electrode on a first substrate, forming an absorption layer on the first electrode, the absorption layer including at least one amorphous silicon layer and at least one microcrystal silicon layer, forming a second electrode on the absorption layer, and forming a second substrate on the second electrode.

In another aspect, the thin film solar cell and method of manufacturing the same includes a thin film solar cell including a first electrode on a first substrate, an absorption layer on the first electrode, the absorption layer including at least one amorphous silicon layer and at least one microcrystal silicon layer, a second electrode on the absorption layer, and a second substrate on the second electrode.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a cross-sectional diagram illustrating a thin film solar cell according to a first exemplary embodiment;

FIGs. 2A to 2D are cross-sectional diagrams illustrating a method of manufacturing a thin film solar cell according to a second exemplary embodiment of the present invention;

FIGs. 3A to 3E are cross-sectional diagrams illustrating a method of manufacturing a thin film solar cell according to a third exemplary embodiment of the present invention;

FIGs. 4A to 4D are cross-sectional diagrams illustrating a method of manufacturing a thin film solar cell according to a fourth exemplary embodiment of the present invention;

FIGs. 5A to 5D are cross-sectional diagrams illustrating a method of manufacturing a thin film solar cell according to a fifth exemplary embodiment of the present invention; and

FIG. 6 is a graph illustrating wavelength ranges absorbed by an exemplary absorption layer in a solar spectrum.

### DETAILED DESCRIPTION OF THE EXEMPLARY EMBODIMENTS

Reference will now be made in detail to the embodiments of the present invention, examples of which are illustrated in the accompanying drawings.

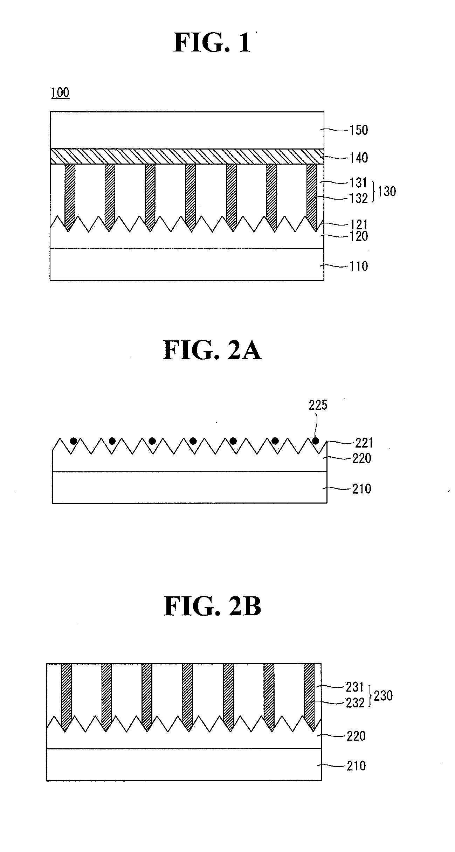

FIG. 1 is a cross-sectional diagram illustrating a thin film solar cell according to a first exemplary embodiment.

As shown in FIG. 1, the thin film solar cell 100 includes a substrate 110, a first electrode 120 disposed on the substrate 110, an absorption layer 130 disposed on the first electrode 120, a second electrode 140 disposed on the absorption layer 130, and an opposite substrate 150 disposed on the second electrode 140. The absorption layer 130 may also include amorphous silicon films 131 and polysilicon films 132, which are alternately disposed in a vertical direction to the substrate 110.

The substrate 110 may be formed of glass or transparent resin. The glass may be sheet glass including, as main components, silicon oxide (SiO2), sodium oxide (Na2O), and calcium oxide (CaO) having transparency and a high insulating property.

The first electrode 120 may be made of transparent conductive oxide or metal. Any one selected from the group consisting of zinc oxide (ZnO), stannic oxide (SnO), cadmium oxide (Cd2O3), and indium tin oxide (ITO) may be used as the transparent conductive oxide. Silver (Ag) or aluminum (Al) may be used as the metal.

Further, the first electrode 120 may have a single layer consisting of the transparent conductive oxide or the metal, but is not limited thereto. For example, the first electrode 120 may have two or more stack layers of the transparent conductive oxide and the metal. Further, the first electrode 120 may include irregularities 121 on its surface. The irregularities 121 may function to widen the surface area of the first electrode 120 so that a greater amount of light can be absorbed.

The absorption layer 130 may include the amorphous silicon films (a-Si:H) 131 and the polysilicon films (µc-Si:H) 132, which are alternately formed in a vertical direction to the substrate 110. When a visible ray is incident on the absorption layer 130, the absorption layer 130 absorbs the visible ray and generates electron-hole pairs. The generated electron-hole pairs are moved to the first electrode 120 and the second electrode 140, respectively.

In the thin film solar cell 100, the amorphous silicon films 131 absorb a short wavelength range of a visible ray, and the polysilicon films 132 absorb a long wavelength range of a visible ray. Accordingly, the thin film solar cell 100, including both the amorphous silicon films 131 and the polysilicon films 132, has a greater efficiency than a conventional film solar cell including only the amorphous silicon films.

In order to efficiently absorb a visible ray, a cross section of the polysilicon films 132 and the amorphous silicon films 131 in a vertical direction to the substrate 110 may have a stripe pattern shape.

Further, in order to move the generated electrons and holes to the first electrode 120 and the second electrode 140, one end of the polysilicon films 132 and the amorphous silicon films 131 may come into contact with the first electrode 120, and the other end of the polysilicon films 132 and the amorphous silicon films 131 may come into contact with the second electrode 140.

The second electrode 140 may be made of transparent conductive oxide or metal like the first electrode 120. ITO, SnO2, or ZnO may be used as the transparent conductive oxide. Ag or Al may be used as the metal. Further, the second electrode 140 may have a single layer consisting of the transparent conductive oxide or the metal, but is not limited thereto. For example, the second electrode 140 may have two or more stack layers of the transparent conductive oxide and the metal.

The opposite substrate 150 may be the same as the substrate 110 and may be made of glass or transparent resin. The glass may be sheet glass including, as main components, SiO2, Na2O, and CaO having transparency and a high insulating property.

A method of manufacturing the exemplary thin film solar cell having the structure shown in FIG. 1 is now described. FIGS. 2A to 2D are cross-sectional diagrams illustrating a method of manufacturing a thin film solar cell according to a second exemplary embodiment.

As shown in FIG. 2A, a first electrode 220 is formed on a substrate 210. The substrate 210 may be made of glass or transparent resin. The glass may be flat sheet glass including, as main components, SiO2, Na2O, and CaO having transparency and a high insulating property.

The first electrode 220 may be formed by depositing transparent conductive materials on the substrate 210. The first electrode 220 may be formed using a chemical vapor deposition (CVD) method, a physical vapor deposition (PVD) method, or an electron-beam (E-beam) method. Here, the first electrode 220 may be made of transparent conductive oxide or metal. Any one of ZnO, SnO, Cd2O3, and ITO may be used as the transparent conductive oxide. Ag or Al may be used as the metal. In addition, the first electrode 220 may have a single layer consisting of the transparent conductive oxide or the metal, but is not limited thereto. For example, the first electrode 220 may have two or more stack layers of the transparent conductive oxide and the metal.

After forming the first electrode 220, irregularities 221 are formed on a surface of the first electrode 220 using a chemical etching method or a physical etching method. The irregularities 221 may function to widen the surface area of the first electrode 220 so that a greater amount of light can be absorbed.

Metal seeds 225 are selectively deposited on the first electrode 220. The metal seeds 225 may be made of any one ofNi, Pd, Ti, Ag, Au, Al, Sn, Sb, Cu, Co, Cr, Mo, Tr, Ru, Rh, and Pt. The metal seeds 225 may be formed by depositing a thin film using a known metal deposition method, such as sputtering, and patterning the thin film.

As shown in FIG. 2B, an absorption layer 230 is formed over the substrate 210, including the metal seeds 225. The absorption layer 230 includes amorphous silicon films 231 and polysilicon films 232, which are alternately formed in a vertical direction to the substrate 210.

In more detail, silicon may be deposited over the substrate 210 including the metal seeds 225 in a chamber using a plasma-enhanced chemical vapor deposition (PECVD). In this case, the chamber may have a temperature of about 400 to 600°C, and the silicon film may be deposited to a thickness of about 1 to 2 µm. If silicon is deposited over the substrate 210, including the metal seeds 225, in the chamber atmosphere of a high temperature, the silicon of regions where the metal seeds 225 are formed may be crystallized and grown into the polysilicon films (µc-Si:H) 232. The silicon of regions where the metal seeds 225 are not formed may be grown into amorphous silicon and become the amorphous silicon films (a-Si:H) 231.

Accordingly, the absorption layer 230 may be formed to have the amorphous silicon films 231 and the polysilicon films 232 which are alternately formed in a vertical direction to the substrate 210. The amorphous silicon films 231 and the polysilicon films 232 of the absorption layer 230 may have a stripe pattern shape in a vertical direction to the substrate 210. The amorphous silicon films 231 and the polysilicon films 232 may also be formed inclinedly to the substrate 210.

Here, in order to transfer electrons and holes created by absorbing sunlight to the first electrode 210, one end of the polysilicon films 232 and the amorphous silicon films 231 are formed to come into contact with the first electrode 210.

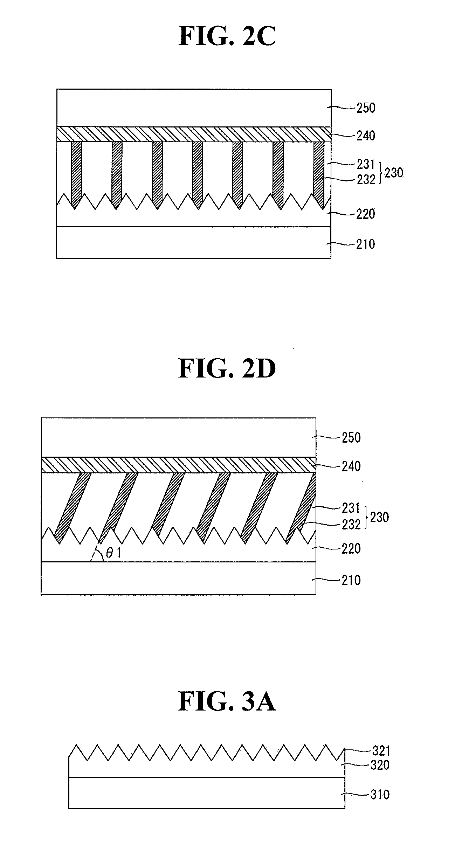

As shown in FIG. 2C, a second electrode 240 is formed over the substrate 210 including the absorption layer 230 and the first electrode 220. The second electrode 240 may be formed using a CVD method, a PVD method, or an E-beam method in the same manner as the first electrode 220. The second electrode 240 may be made of transparent conductive oxide or metal in the same manner as the first electrode 220. ITO, SnO2, or ZnO may be used as the transparent conductive oxide. Ag or Al may be used as the metal. Further, the second electrode 240 may have a single layer consisting of the transparent conductive oxide or the metal, but is not limited thereto. For example, the second electrode 240 may have two or more stack layers of the transparent conductive oxide and the metal.

An opposite substrate 250 is formed on the second electrode 240, thereby completing the thin film solar cell according to the second embodiment.

As shown in FIG. 2D, in the silicon deposition process illustrated in FIG. 2B, the substrate 210 may be inclined and a silicon layer may be deposited on the substrate 210 to form the polysilicon films 232. Thus, the polysilicon films 232 may be formed inclinedly to the substrate 210 in a region where the metal seeds 225 are formed, and the amorphous silicon films 231 may be formed simultaneously with the formation of the polysilicon films 232. An inclination angle θ1 between the amorphous silicon films 231 and the substrate 210 and between the polysilicon films 232 and the substrate 210 may be between approximately 45° and 90°. The second electrode 240 and the opposite substrate 250 may be formed to complete the thin film solar cell.

As described above, in the method of manufacturing the thin film solar cell according to the second embodiment, the absorption layer including the amorphous silicon films and the polysilicon films is formed on the first electrode using the metal seeds. Accordingly, the efficiency of the thin film solar cell can be improved because the amorphous silicon films can absorb a short wavelength range of a visible ray and the polysilicon films can absorb a long wavelength range of a visible ray.

FIGs. 3A to 3E are cross-sectional diagrams illustrating a method of manufacturing a thin film solar cell according to a third exemplary embodiment.

As shown in FIG. 3A, a first electrode 320 is first formed on a substrate 310. Similar to the second embodiment, the first electrode 320 may include irregularities 321. The irregularities 321 may function to widen the surface area of the first electrode 320 such that a greater amount of light can be absorbed.

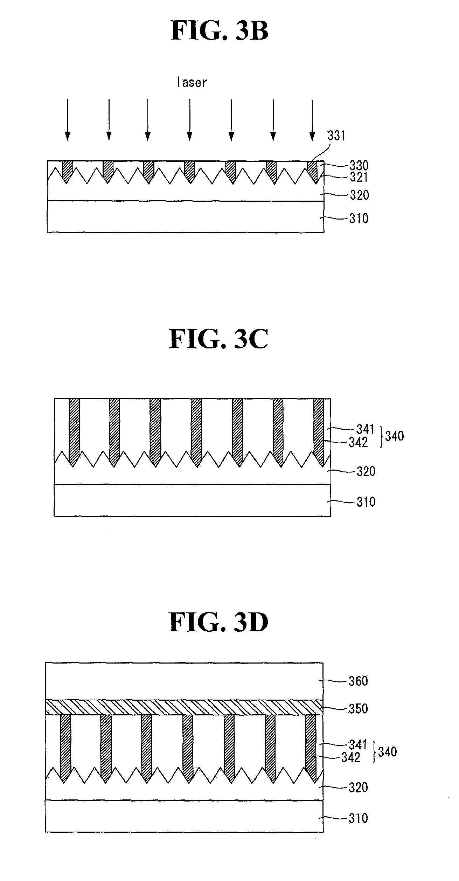

As shown in FIG. 3B, amorphous silicon 330 is deposited on the first electrode 320. Some regions of the amorphous silicon 330 are irradiated with a laser, thereby being crystallized into polysilicon 331.

Here, the amorphous silicon 330 deposited on the first electrode 320 may have a thickness of about 500 Å, and the polysilicon 331 crystallized by the laser is spaced apart from each other. The polysilicon 331 may function to form polysilicon films like the metal seeds of the second embodiment.

As shown in FIG. 3C, an absorption layer 340 including amorphous silicon films 341 and polysilicon films 342 is formed by epitaxially growing the amorphous silicon 330 and the polysilicon 331. The epitaxial growth process is one of the crystal growth methods and is used to grow a new crystal using a crystal formed on a substrate as a seed. Here, the new crystal may have the same crystal structure and directivity as the crystal formed on the substrate. The epitaxial growth method may include a liquid phase epitaxial (LPE) method, a vapor phase epitaxial (VPE) method, or a molecular beam epitaxial (MBE) method, but is not limited thereto.

In view of the characteristic of the epitaxial growth process, the amorphous silicon films 341 and the polysilicon films 342, respectively grown from the amorphous silicon 330 and the polysilicon 331, have the same crystal structure and directivity as the amorphous silicon 330 and the polysilicon 331, respectively. Accordingly, the polysilicon films 342 may be formed in the regions where the polysilicon 331 is formed.

Accordingly, the absorption layer 340, which may be formed over the substrate 310, includes the amorphous silicon films 341 and the polysilicon films 342, which are alternately formed in a vertical direction to the substrate 310. The amorphous silicon films 341 and the polysilicon films 342 of the absorption layer 340 may have a stripe pattern shape in a vertical direction to the substrate 310.

In this case, in order to transfer electrons and holes created by absorbing sunlight to the first electrode 320, one end of the polysilicon films 342 and the amorphous silicon films 341 are formed to come into contact with the first electrode 320.

As shown in FIG. 3D, a second electrode 350 is formed over the substrate 310 including the absorption layer 340 and the first electrode 320. An opposite substrate 360 is formed on the second electrode 350, thereby completing the thin film solar cell according to the third embodiment. The amorphous silicon films 341 and the polysilicon films 342 may be formed inclinedly to the substrate 310.

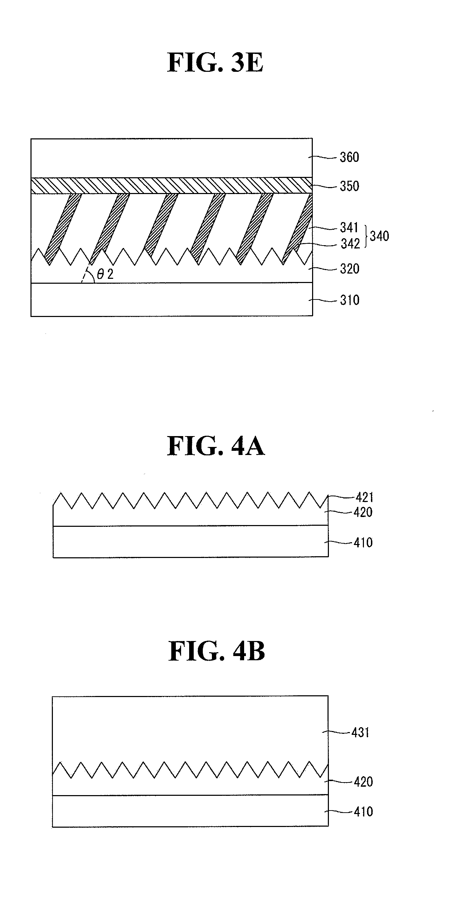

As shown in FIG. 3E, in the laser irradiation process illustrated in FIG. 3B, the substrate 310 may be inclined and the polysilicon films 342 may be formed inclinedly to the substrate 310 through the laser irradiation. Afterwards, in the epitaxial growth process illustrated in FIG. 3c, the epitaxial growth process may be performed in a state where the substrate 310 is inclined. Hence, the amorphous silicon films 341 and the polysilicon films 342 may be formed inclinedly to the substrate 310. An inclination angle θ2 between the amorphous silicon films 341 and the substrate 310 and between the polysilicon films 342 and the substrate 310 may be between approximately 45° and 90°. The second electrode 350 and the opposite substrate 360 may be formed to complete the thin film solar cell.

As described above, in the method of manufacturing the thin film solar cell according to the third embodiment of this document, after thinly forming the amorphous silicon and the polysilicon on the first electrode, the amorphous silicon and the polysilicon are grown to thereby form the absorption layer. Accordingly, there is an advantage in that efficiency of the thin film solar cell can be improved because the amorphous silicon films can absorb a short wavelength range of a visible ray and the polysilicon films can absorb a long wavelength range of a visible ray.

FIGS. 4A to 4D are cross-sectional diagrams illustrating a method of manufacturing a thin film solar cell according to a fourth exemplary embodiment.

As shown in FIG. 4A, a first electrode 420 is formed on a substrate 410. Like the first embodiment, the first electrode 420 may include irregularities 421. The irregularities 421 may function to widen the surface area of the first electrode 420 such that a greater amount of light can be absorbed.

As shown in FIG. 4B, an amorphous silicon film (a-SiGe:H) 431 is formed on the first electrode 420. The amorphous silicon film 431 may be formed to a thickness of about 1.5 to 2 µm using a PECVD method.

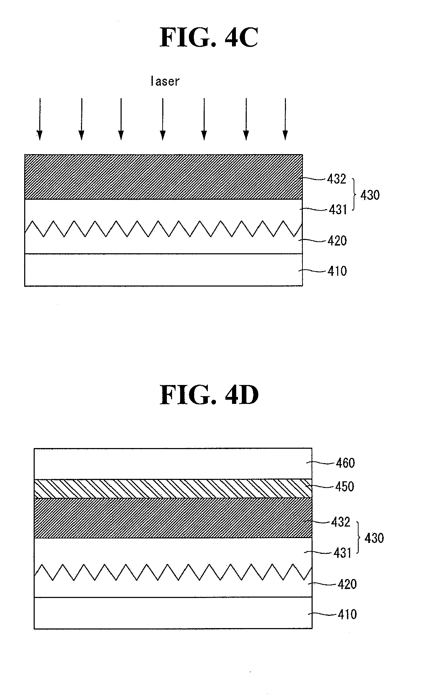

As shown in FIG. 4C, a top surface of the amorphous silicon film 431 is crystallized by irradiating the entire surface of the substrate 410, including the amorphous silicon film 431, with a laser, thereby forming a polysilicon film 432. Here, an excimer laser can be used as the laser for crystallizing the amorphous silicon film 431. Further, the excimer laser may have irradiation conditions, including a scan rate of about 0.1 to 2.5 mm/s, a frequency of about 10 to 150 Hz, and an energy density of about 300 to 400 mJ/cm².

Further, the crystallized polysilicon film 432 may be made of µc-SiGe:H because the amorphous silicon film 431 is a-SiGe:H comprising Ge. In this case, the optical band gap of each of the amorphous silicon film 431 and the polysilicon films 432 can be controlled by controlling the amount of Ge. That is, the optical band gap of the amorphous silicon film 431 may be controlled to be 1.4 to 1.6 eV, and the optical band gap of the polysilicon film 432 may be controlled to be 1.4 to 1.6 eV.

Accordingly, an absorption layer 430 including the amorphous silicon film 431 and the polysilicon film 432 may be formed. In this case, the amorphous silicon film 431 may have a thickness of about 500 to 800 nm, and the polysilicon film 432 may have a thickness of about 1000 to 1500 nm.

As shown in FIG. 4D, a second electrode 450 is formed over the substrate 410 including the absorption layer 430 and first electrode 420. An opposite substrate 460 is formed on the second electrode 450, thereby completing the thin film solar cell according to the fourth embodiment.

As described above, in the method of manufacturing the thin film solar cell according to the fourth embodiment, the amorphous silicon film is formed on the first electrode, and part of the amorphous silicon film is crystallized using a laser. Accordingly, there is an advantage in that the turn-around time of a PECVD method for forming the polysilicon film can be reduced.

Further, the absorption layer is formed to include the amorphous silicon film and the polysilicon film. Accordingly, there is an advantage in that efficiency of the thin film solar cell can be improved because the amorphous silicon film can absorb a short wavelength range of a visible ray and the polysilicon film can absorb a long wavelength range of a visible ray.

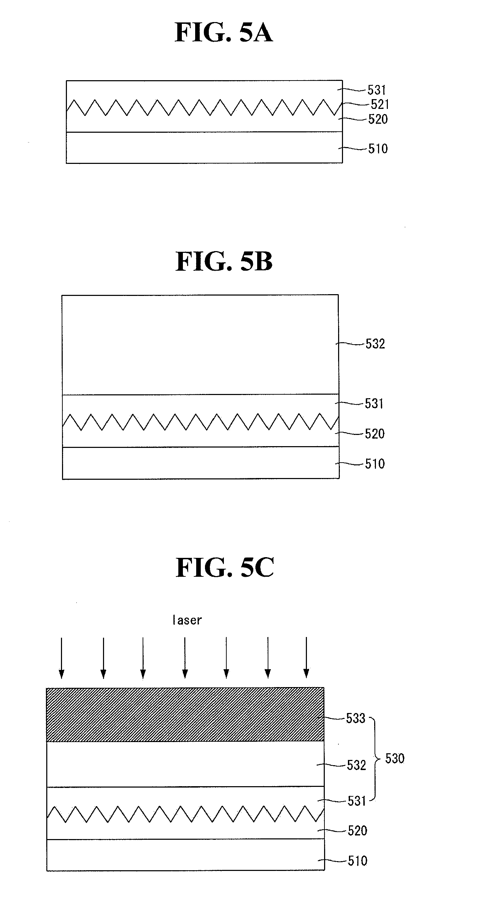

FIGs. 5A to 5D are cross-sectional diagrams illustrating a method of manufacturing a thin film solar cell according to a fifth exemplary embodiment.

As shown in FIG. 5A, a first electrode 520 is formed on a substrate 510. Like the first embodiment, the first electrode 520 may include irregularities 521. The irregularities 521 may function to widen the surface area of the first electrode 520 such that a greater amount of light can be absorbed.

A lower amorphous silicon film (a-Si:H) 531 is formed on the first electrode 520. Here, the lower amorphous silicon film 531 may be formed to a thickness of about 100 to 300 nm using a PECVD method.

As shown in FIG. 5B, an upper amorphous silicon film (a-SiGe:H) 532 is formed over the substrate 510 including the lower amorphous silicon film 531. The upper amorphous silicon film 532 may have a thickness of about 1 to 1.5 µm and may further include Ge unlike the lower amorphous silicon film 531.

As shown in FIG. 5C, a top surface of the upper amorphous silicon film 532 is crystallized by irradiating the upper amorphous silicon film 532 with a laser, thereby forming a polysilicon film 533. Here, an excimer laser may be used as the laser for crystallizing the upper amorphous silicon film 532. Further, the excimer laser may have irradiation conditions, including a scan rate of about 0.1 to 2.5 mm/s, a frequency of about 10 to 150 Hz, and an energy density of about 300 to 400 mJ/cm².

Further, the crystallized polysilicon film 533 can be made of µc-SiGe:H because the upper amorphous silicon film 532 is a-SiGe:H including Ge. In this case, the optical band gap of each of the upper amorphous silicon film 532 and the polysilicon films 533 can be controlled by controlling the amount of Ge. That is, the optical band gap of the upper amorphous silicon film 532 may be controlled to be 1.4 to 1.6 eV, and the optical band gap of the polysilicon film 533 may also be controlled to be 1.4 to 1.6 eV. Meanwhile, the optical band gap of the lower amorphous silicon film 531 not including Ge may be controlled to be 1.7 eV.

Accordingly, an absorption layer 530 including the lower amorphous silicon film 531, the upper amorphous silicon film 532, and the polysilicon film 533 can be formed. In this case, the lower amorphous silicon film 531 may have a thickness of about 100 to 300 nm, the upper amorphous silicon film 532 may have a thickness of about 50 to 200 nm, and the polysilicon film 533 may have a thickness of about 200 to 300 nm.

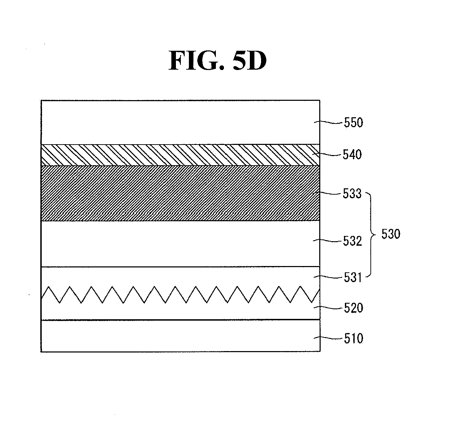

As shown in FIG. 5D, a second electrode 540 is formed over the substrate 510 including the absorption layer 530 and the first electrode 520. An opposite substrate 550 is formed on the second electrode 540, thereby completing the thin film solar cell according to the fifth embodiment of this document.

As described above, in the method of manufacturing the thin film solar cell according to the fifth embodiment, the lower amorphous silicon film is formed on the first electrode, the upper amorphous silicon film is formed on the lower amorphous silicon film, and part of the upper amorphous silicon film is crystallized using a laser. Accordingly, there is an advantage in that the turn-around time of a PECVD method for forming the polysilicon film can be reduced.

Further, the absorption layer is formed to include the lower amorphous silicon film not including Ge and the upper amorphous silicon film and the polysilicon film, both of which include Ge. Accordingly, there is an advantage in that efficiency of the thin film solar cell can be improved because the upper amorphous silicon film can absorb a short wavelength range of a visible ray, the polysilicon film can absorb a long wavelength range of a visible ray, and the lower amorphous silicon film can absorb a range of a visible ray between the short wavelength and the long wavelength.

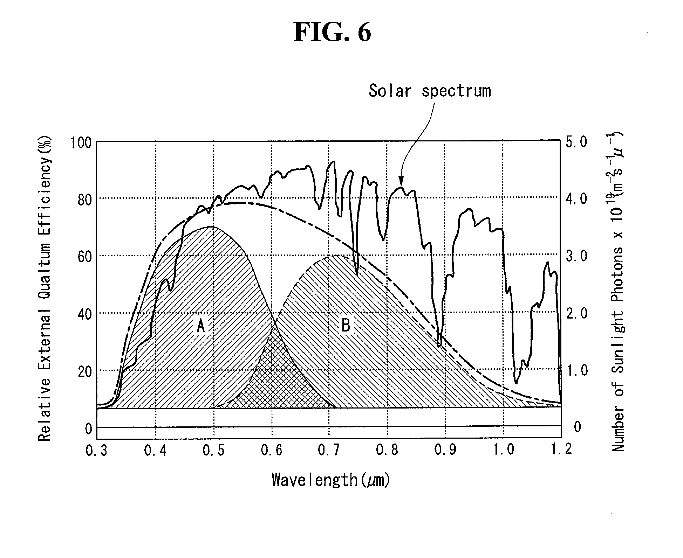

FIG. 6 is a graph illustrating wavelength ranges absorbed by an exemplary absorption layer in a solar spectrum. As shown in FIG. 6, the thin film solar cell according to the first to fifth embodiments includes the absorption layer consisting of the polysilicon film and the amorphous silicon film. Accordingly, there is an advantage in that the amorphous silicon film can absorb a short wavelength range A of sunlight and the polysilicon film can absorb a long wavelength range B of sunlight.

Accordingly, the present invention is advantageous in that it can improve efficiency of a thin film solar cell by absorbing a wide wavelength range of sunlight when compared to a conventional absorption layer comprising only an amorphous silicon film.

It will be apparent to those skilled in the art that various modifications and variations can be made in the thin film solar cell and method of manufacturing the same of the present invention without departing from the spirit or scope of the invention. Thus, it is intended that the present invention cover the modifications and variations of this invention provided they come within the scope of the appended claims and their equivalents.

## Claims

1. A thin film solar cell, comprising:
a first substrate;
a first electrode on the first substrate, an upper surface of the first electrode having a plurality of irregularities;
an absorption layer on the first electrode, the absorption layer including amorphous silicon layers and microcrystal silicon layers contacting the first electrode at an angle relative to the first substrate;
a second electrode on the absorption layer; and
a second substrate on the second electrode.

2. The thin film solar cell according to claim 1 wherein the amorphous silicon layers and the microcrystal silicon layers may be formed in a stripe pattern shape.

3. The thin film solar cell according to claim 1 wherein each of the microcrystal silicon layers and the amorphous silicon layers contacts the first and second electrodes.

4. The thin film solar cell according to claim 1 wherein the amorphous silicon layers and microcrystal silicon layers of the absorption layer contact the first electrode at an angle perpendicular to the first substrate.

5. The thin film solar cell according to claim 1 wherein the amorphous silicon layers and microcrystal silicon layers of the absorption layer contact the first electrode at an angle between 45 and 90 degrees relative to the first substrate.

6. The thin film solar cell according to claim 1 wherein the microcrystal silicon layers of the absorption layer are formed by depositing a plurality of metal seeds.

7. The thin film solar cell according to claim 1 wherein the absorption layer including an amorphous silicon layer and a microcrystal silicon layer formed parallel to the first and second electrodes.

8. The thin film solar cell of claim 7 wherein the amorphous silicon layer is formed on an entire surface of the first electrode and the microcrystal silicon layer is formed on an entire surface of the amorphous silicon layer.

9. A method for fabricating a thin film solar cell, comprising the steps of:
preparing a first substrate;
forming a first electrode on the first substrate, an upper surface of the first electrode having a plurality of irregularities;
depositing a plurality of metal seeds on the first electrode;
forming an absorption layer on the first electrode, the absorption layer including amorphous silicon layers and microcrystal silicon layers, the microcrystal layers being formed of the plurality of metal seeds;
forming a second electrode on the absorption layer; and
forming a second substrate on the second electrode.

10. The method for fabricating a thin film solar cell according to claim 9 wherein the amorphous silicon layers and the microcrystal silicon layers contact the first electrode at an angle relative to the first substrate.

11. The method for fabricating a thin film solar cell according to claim 10 wherein the amorphous silicon layers and microcrystal silicon layers of the absorption layer contact the first electrode at an angle perpendicular to the first substrate.

12. The method for fabricating a thin film solar cell according to claim 10 wherein the amorphous silicon layers and microcrystal silicon layers of the absorption layer contact the first electrode at an angle between 45 and 90 degrees relative to the first substrate.

13. The method for fabricating a thin film solar cell according to claim 9 wherein the amorphous silicon layers and the microcrystal silicon layers may be formed in a stripe pattern shape.

14. The method for fabricating a thin film solar cell according to claim 9 wherein each of the microcrystal silicon layers and the amorphous silicon layers contact the first and second electrodes.

15. The method for fabricating a thin film solar cell according to claim 9 wherein the microcrystal layer is formed by irradiating an upper surface of the amorphous silicon layer.
